# EUROPÄISCHE PATENTANMELDUNG

(11) **EP 3 671 966 A1**
(43) Veröffentlichungstag der Anmeldung: **24.06.2020**
(21) Anmeldenummer: 19210178.0
(22) Anmeldetag: 19.11.2019
(51) Int. Cl.: H01R 12/70, H01R 12/72

(54) **DIREKTSTECKVERBINDER FÜR EINE LEITERPLATTE**

(30) Priorität: 17.12.2018 DE 102018132405
(71) Anmelder: EBM-PAPST Landshut GmbH, 84030 Landshut (DE)
(72) Erfinder: Wald, Stephan, 48341 Altenberge (DE); Kleine, Volker, 49143 Bissendorf (DE)
(74) Vertreter: Staeger & Sperling Partnerschaftsgesellschaft mbB

(57) **Zusammenfassung**

Die Erfindung betrifft eine Leiterplattensteckverbindung (1) umfassend eine Leiterplatte (10) mit einem elektrische Kontakte (11) aufweisenden Einsteckabschnitt (12) und einen auf den Einsteckabschnitt (12) der Leiterplatte (10) aufsteckbaren Steckverbinder (20) zur elektrischen Verbindung des Steckverbinders (20) mit der Leiterplatte (10), wobei der Einsteckabschnitt (12) benachbart zu einer Seitenkante (13) der Leiterplatte (10) ausgebildet ist und wenigstens ein von der Leiterplatte (10) gebildeter federnder Rastarm (15) im Bereich des Einsteckabschnittes (12) zur Verrastung des Steckverbinders (20) vorgesehen ist.

## Beschreibung

Die Erfindung betrifft einen Direktsteckverbinder für eine Leiterplatte.

Aus dem Bereich der elektrischen Verbindungstechnik ist bekannt, dass zur elektrischen Verbindung eines Steckverbinders mit einer Leiterplatte der Steckverbinder auf die Leiterplatte aufgesteckt wird. Hierzu sind eine Vielzahl von Steckverbinderlösungen bekannt, bei denen ein Stecksockel oder eine Steckleiste auf der Leiterplatte montiert ist, in die ein entsprechend geformter Gegenstecker eingesteckt wird.

Eine direkte Verbindung des Steckverbinders mit der Leiterplatte findet dabei jedoch regelmäßig nicht statt. Um den Steckverbinder mit der Leiterplatte elektrische zu verbinden, wird der Steckverbinder im Allgemeinen in eine mit der Leiterplatte elektrische verbundene Grundleiste eingesteckt und mit der Steckleiste über Rastvorrichtungen verrastet. Auf diese Weise ist der Steckverbinder über die Steckleiste mit der Leiterplatte elektrisch verbunden und mit der Steckleiste verrastet.

Zur mechanischen Verbindung des auf die Leiterplatte aufgesteckten und mit der Leiterplatte elektrisch verbundenen Steckverbinders, bedarf es somit eines weiteren Bauteils und eines weiteren Arbeitsschritts.

Es gibt ferner Lösungen im Stand der Technik, bei der ein Rastelement des Steckverbinders in Rastausnehmungen der Leiterplatte verrastet. Solche Lösungen sind zum Beispiel aus der US 5647755 A und der US 8475195 B2 bekannt. Bei Steckverbindern mit integrierten Rastelementen besteht der Nachteil darin, dass diese aufwändig und spezifisch für den jeweiligen Anwendungsfall konfektioniert werden müssen. Ferner können die Rasthaken am Steckverbinder beschädigt werden, so dass eine zuverlässige Verbindung danach nicht mehr gewährleistet ist.

Ferner gibt es Lösungen im Stand der Technik, bei der eine mechanische Verbindung zwischen einem Steckverbinder über Klemmmittel realisiert wird. So ist aus der EP 2075877 A2 eine Verbindungslösung bekannt, bei der ein Steckverbinder zum Anschluss an eine flexible Leiterplatte vorgeschlagen wird, wobei der Steckverbinder folgendes aufweist: einen Kontakte tragenden Kontaktträger, der beweglich am Kontaktträger gelagerte vorzugsweise aus Metall bestehenden Andruckmittel, und Deckellagermittel, die eine Bewegung der Andruckmittel zwischen einer Leiterplattenaufnahmestellung und einer Deckelschließstellung gestatten, ausfweist und wobei die Andruckmittel in der Deckelschließstellung die Kontakte gegen die Leiterplatte und deren Kontaktbahnen gegen die Kontakte zu drücken.

Nachteilig ist dabei, dass man ein zusätzliches Bauteil benötigt und diese Lösung bei herkömmlichen insbesondere nicht flexiblen Leiterplatten nicht zuverlässig bei Anwendungen einsetzbar ist, die thermischen und mechanischen Belastungen und insbesondere Vibrationen ausgesetzt sind.

Es ist daher die Aufgabe der vorliegenden Erfindung, vorbesagte Nachteile zu überwinden und eine elektrische Leiterplattensteckverbindung anzugeben, die eine geringe Bauhöhe aufweist und mit der ein auf die Leiterplatte aufgesteckter und mit der Leiterplatte elektrisch verbundener Steckverbinder auf einfache und verlässliche Weise mit der Leiterplatte verrastbar ist.

Diese Aufgabe wird durch den Gegenstand des Anspruchs 1 gelöst.

Ein Grundgedanke der vorliegenden Erfindung liegt darin, dass die Leiterplatte mit einer federnden Rastvorrichtung integral ausgebildet wird. Erfindungsgemäß wird hierzu eine Leiterplattensteckverbindung vorgeschlagen, umfassend eine Leiterplatte mit einem elektrische Kontakte aufweisenden Einsteckabschnitt (Kontaktierungsbereich) und einen auf den Einsteckabschnitt der Leiterplatte aufsteckbaren Steckverbinder zur elektrischen Verbindung des Steckverbinders mit der Leiterplatte (bzw. den jeweiligen Kontakten), wobei der Einsteckabschnitt benachbart zu einer Seitenkante der Leiterplatte ausgebildet ist und wenigstens ein von der Leiterplatte gebildeter federnder Rastarm im Bereich des Einsteckabschnittes zur Verrastung des Steckverbinders vorgesehen ist.

In einer bevorzugten Ausgestaltung der Erfindung ist vorgesehen, dass zwei federnde Rastarme im Bereich des Einsteckabschnittes zur Verrastung des Steckverbinders vorgesehen sind. Hierdurch kann die Verrastung unter Berücksichtigung von Lage- und Formtoleranzen noch zuverlässiger realisiert werden und die angreifenden Federkräfte können entsprechend aufgeteilt werden.

Ebenfalls von Vorteil ist eine Ausgestaltung, bei der der Einsteckabschnitt als eine Ausnehmung oder Ausklinkung, besonders bevorzugt eine im Wesentlichen U-förmige Ausnehmung mit einer zur Seitenkante (an der die Ausnehmung eingebracht ist) nach innen versetzten Längsseitenkante in der Leiterplatte vorgesehen ist, wobei die Leiterplatten-Kontakte entlang dieser Längsseitenkante angeordnet sind.

Vorteilhaft ist dabei eine Ausgestaltung bei der die Kontakte im Bereich des Einsteckabschnitts als nicht federnde Kontakt-Pads wenigstens auf einer Oberseite oder Unterseite der Leiterplatte ausgebildet sind und die Kontakte des Steckverbinders als Federkontakte ausgebildet sind.

In einer bevorzugten Ausgestaltung der Erfindung ist vorgesehen, dass sich der oder die Rastarme von der Längsseitenkante in der Leiterplattenebene weg erstrecken. Hierdurch wird gewährleistet, dass eine besonders flache Bauform der Steckverbindung realisierbar ist. Weiter vorteilhaft ist es, wenn sich dabei der oder die Federarme über die gesamte Tiefe der Ausnehmung bis an den Rand der Leiterplatte bzw. bis zur außenliegenden Seitenkante erstrecken. Hierdurch kann ein vergleichsweise langer Federarm realisiert werden, so dass sich die Federkräfte, je nach konstruktiver Ausgestaltung effizient skalieren lassen.

In einer weiteren bevorzugten Ausgestaltung der Erfindung ist vorgesehen, dass sich der oder die Rastarme von der Längsseitenkante weg und zwar in der Leiterplattenebene in den Bereich der U-förmigen Ausnehmung hinein erstrecken. Weiter bevorzugt ist es dabei, wenn die Federarme dabei vollständig innerhalb der Leiterplattenebene ein- und ausfedern können und nicht mit ihrem Federarmende aus der Leiterplattenebene hervorstehen.

Erfindungsgemäß ist weiter mit Vorteil vorgesehen, dass sich an den federnden Rastarmen und zwar quer zur Erstreckungsrichtung der Federarme hervorstehende Rastnasen befinden. Diese Rastnasen dienen der Verriegelung des Steckverbinders. Bei herkömmlichen Leiterplattensteckverbinder mit rechteckiger Bauform können dabei z. B. ohne konstruktive Änderung der Steckverbindergehäuse vorhandene Gehäusekanten zur Verrastung genutzt werden, indem die Haltenasen einen entsprechend ausgebildeten Hinterschnitt oder eine Kante besitzen, der hinter die genannte Steckverbindergehäusekante greift und das Gehäuse so fixiert.

Ferner ist mit Vorteil vorgesehen, dass sich die jeweilige Rastnase des jeweiligen einen Federarms in Richtung zu dem jeweils anderen Federarm innerhalb der Leiterplattenebene erstreckt. Auf diese Weise kann ein Umgriff des Leiterplattensteckverbinders auf einfache Weise realisiert werden, wobei auch gewisse Fertigungstoleranzen besonders effizient mit abgefangen werden können, aber die Verriegelung dennoch zuverlässig funktioniert.

In einer weiteren vorteilhaften Ausgestaltung der Erfindung ist vorgesehen, dass der Steckverbinder ein Steckverbindergehäuse besitzt und die Breite der Ausnehmung so gewählt ist, dass der Steckverbinder mit seinem Steckverbindergehäuse oder wenigstens im Bereich seines Steckabschnitts des Steckverbindergehäuses vollständig in die Ausnehmung eingeschoben ist und im vollständig eingesteckten Zustand die hervorstehenden Rastnasen der Federarme an entsprechenden Gegenrastmittel des Steckverbindergehäuses ein- oder hintergreifen und dadurch den Steckverbinder mit der Leiterplatte verrasten.

Weiter ist vorgesehen, dass die Konstruktion so vorgenommen ist, dass beim Einstecken des Steckverbinders auf den Einsteckabschnitt der Leiterplatte der oder die von der Leiterplatte ausgebildeten federnden Rastarme innerhalb der Leiterplattenebene in einer Richtung quer zur Einsteckrichtung federnd ausgelenkt werden und beim Erreichen der vollständig gesteckten Position, vorzugsweise ein hörbares und/oder sichtbares Einrasten erfolgt. Alternativ könnte auch über optisch sichtbare Marker oder Mittel ein optisch sichtbarer Einrastzustand ergänzend oder alternativ realisiert werden.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1a, 1b: ein erstes Ausführungsbeispiel einer Leiterplattensteckverbindung gemäß der vorliegenden Erfindung und
- Fig. 2a, 2b, 2c: ein zweites Ausführungsbeispiel einer Leiterplattensteckverbindung gemäß der vorliegenden Erfindung.

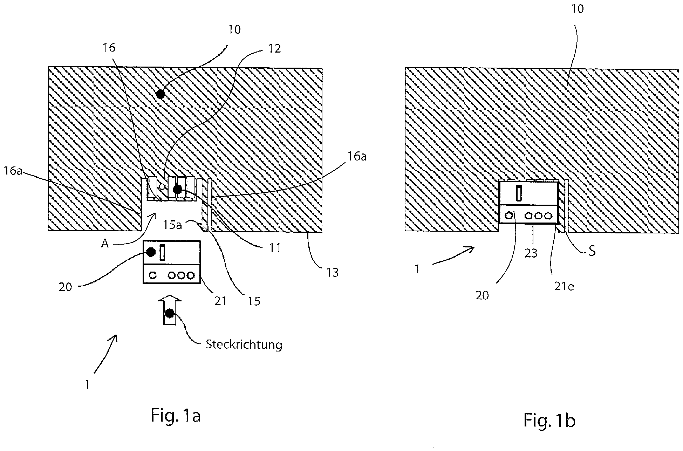

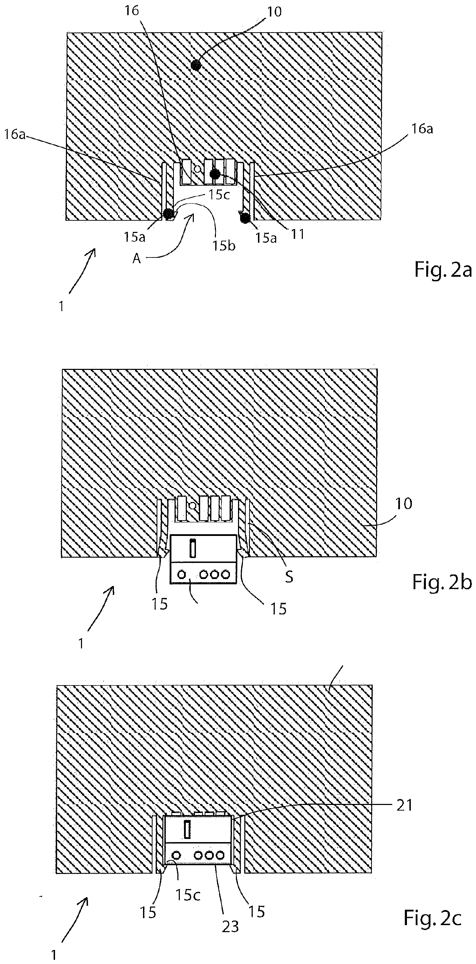

Im Folgenden wird die Erfindung mit Bezug auf die Figuren 1 und 2 näher erläutert, wobei gleiche Bezugszeichen auf gleiche funktionale und/oder strukturelle Merkmale hinweisen.

In den Figuren 1a und 1b ist ein erstes Ausführungsbeispiel einer Leiterplattensteckverbindung 1 gezeigt. Die Leiterplattensteckverbindung 1 umfasst eine Leiterplatte 10 mit einem elektrische Kontakte 11 aufweisenden Einsteckabschnitt 12 und einen auf den Einsteckabschnitt 12 der Leiterplatte 10 aufsteckbaren Steckverbinder 20 zur elektrischen Verbindung des Steckverbinders 20 mit der Leiterplatte 10. Im vorliegenden Ausführungsbeispiel befinden sich mehrere flache Kontaktelemente, sprich Kontakt-Pads 11 auf der Oberfläche der Leiterplatte 10.

Der Einsteckabschnitt 12 ist als eine im Wesentlichen U-förmige Ausnehmung A in der Leiterplatte 10 ausgebildet. Die Ausnehmung A besitzt eine zur Seitenkante 13 der Leiterplatte nach innen versetzte Längsseitenkante 16 und zwei quer dazu verlaufende Seitenkanten 16a. Die Kontakte 11 sind entlang der Längsseitenkante 16 nebeneinander angeordnet.

Der Einsteckabschnitt 12 ist demnach benachbart zu der Seitenkante 13 der Leiterplatte 10 ausgebildet und besitzt in der Ausführungsform nach Figur 1 einen von der Leiterplatte 10 gebildeten federnder Rastarm 15 unmittelbar im Bereich des Einsteckabschnittes 12 zur Verrastung am Steckverbinder 20 aus.

In der alternativen Ausführungsform nach den Figuren 2a bis 2c befinden sich zwei von der Leiterplatte 10 einstückig gebildete federnde Rastarme 15. Wie in den Figuren gut zu erkennen, ist zwischen dem Rastarm 15 und der unmittelbar daneben quer verlaufenden Seitenkante 16a ein Spalt S. Je nach Spaltbreite, Federarmlänge und Materialeigenschaften lassen sich eine gewünschte Federkraft und ein erforderlicher Federweg einstellen. Ferner ist die Federarmgeometrie so gewählt, dass im vollständig eingesteckten Zustand der Federarm 15 in seiner unausgelenkten (nicht federbelasteten) Stellung ist.

In der Abbildung der Figur 2b ist ersichtlich, dass beim Einstecken des Steckverbinders 20 auf den Einsteckabschnitt 12 der Leiterplatte 10 die von der Leiterplatte 10 ausgebildeten federnden Rastarme 15 innerhalb der Leiterplattenebene in einer Richtung quer zur Einsteckrichtung federnd ausgelenkt werden und dann in der vollständig verrasteten Position die hintere Kante 23 des Steckverbindersgehäuses 21 des Steckverbinders 20 hintergreifen und in seiner Position fixieren.

Der Steckverbinder 20 ist in diesem Ausführungsbeispiel so gewählt, dass er vollständig in die Ausnehmung A eintaucht und dadurch eine kompakte Bauform erhalten wird.

An den federnden Rastarmen 15 befinden sich zur Verrastung quer zur Erstreckungsrichtung der Rastarme 15 hervorstehende Rastnasen 15a. In den gezeigten Ausführungsbeispielen besitzen die Rastnasen eine Anlagefläche 15b, die mit einer Anlagefläche 15c des Rastarms 15 einen rechten Winkel bildet, so dass die rechtwinklige Ecke 21e des Steckverbindergehäuses 21 formschlüssig darin gehalten wird.

Durch die beschriebene Leiterplattensteckverbindung wird eine mit dem Bezugspunkt der schwingenden Leiterplatte optimierte Halterung bereit gestellt, da diese mitschwingend den Stecker am Kontaktpunkt fixiert.

Hierbei ist es wie zuvor erwähnt besonders vorteilhaft, dass gegenüber üblichen Lösungen zur Fixierung keine zusätzlichen Halterungen, Klipsen oder Gehäuseabdeckungen benötigt werden und eine einfache und universell einsetzbare Lösung zur sicheren Fixierung eines Leiterplattensteckverbinders 20 bereit gestellt wird.

Die Erfindung beschränkt sich in ihrer Ausführung nicht auf die vorstehend angegebenen bevorzugten Ausführungsbeispiele. Vielmehr ist eine Anzahl von Varianten denkbar, welche von der dargestellten Lösung auch bei grundsätzlich anders gearteten Ausführungen Gebrauch macht. So kann zum Beispiel vorgesehen sein, dass der Steckverbinder 20 im vollständig eingesteckten Zustand an den hervorstehende Rastnasen 15a an entsprechenden im Steckverbindergehäuse 21 seitlich eingeformten Gegenrastmittel verrastet wird, in die die Rastnasen 15a eintauchen.

## Patentansprüche

1. Leiterplattensteckverbindung (1) umfassend eine Leiterplatte (10) mit einem elektrische Kontakte (11) aufweisenden Einsteckabschnitt (12) und einen auf den Einsteckabschnitt (12) der Leiterplatte (10) aufsteckbaren Steckverbinder (20) zur elektrischen Verbindung des Steckverbinders (20) mit der Leiterplatte (10), wobei der Einsteckabschnitt (12) benachbart zu einer Seitenkante (13) der Leiterplatte (10) ausgebildet ist und wenigstens ein von der Leiterplatte (10) gebildeter federnder Rastarm (15) im Bereich des Einsteckabschnittes (12) zur Verrastung des Steckverbinders (20) vorgesehen ist.

2. Leiterplattensteckverbindung (1) gemäß Anspruch 1, **dadurch gekennzeichnet, dass** zwei federnde Rastarme (15) im Bereich des Einsteckabschnittes (12) zur Verrastung des Steckverbinders (20) vorgesehen sind.

3. Leiterplattensteckverbindung (1) gemäß Anspruch 1 oder 2, **dadurch gekennzeichnet, dass** der Einsteckabschnitt (12) als eine im Wesentlichen U-förmige Ausnehmung (A) mit einer zur Seitenkante (13) nach innen versetzten Längsseitenkante (16) in der Leiterplatte (10) vorgesehen ist, wobei die Kontakte (11) entlang der Längsseitenkante (16) angeordnet sind.

4. Leiterplattensteckverbindung (1) gemäß Anspruch 3, **dadurch gekennzeichnet, dass** sich der oder die Rastarme (15) von der Längsseitenkante (16) in der Leiterplattenebene weg erstrecken.

5. Leiterplattensteckverbindung (1) gemäß Anspruch 3 oder 4, **dadurch gekennzeichnet, dass** sich der oder die Rastarme (15) von der Längsseitenkante (16) in der Leiterplattenebene weg in den Bereich der u-förmigen Ausnehmung hinein erstrecken.

6. Leiterplattensteckverbindung (1) gemäß einem der vorhergehenden Ansprüche 2 bis 5, **dadurch gekennzeichnet, dass** sich an den federnden Rastarmen (15) quer zur Erstreckungsrichtung der Federarme hervorstehende Rastnasen (15a) befinden.

7. Leiterplattensteckverbindung (1) gemäß Anspruch 6, **dadurch gekennzeichnet, dass** sich die jeweilige Rastnase (15a) des jeweiligen einen Federarms (15) in Richtung zu dem jeweils anderen Federarm (15) innerhalb der Leiterplattenebene erstreckt.

8. Leiterplattensteckverbindung (1) gemäß einem der vorhergehenden Ansprüche, wobei der Steckverbinder (20) ein Steckverbindergehäuse (21) besitzt und die Breite der Ausnehmung (A) so gewählt ist, dass der Steckverbinder (20) mit seinem Steckverbindergehäuse (21) wenigstens im Bereich seines Steckabschnitts (22) vollständig in die Ausnehmung (A) eingeschoben ist und im vollständig eingesteckten Zustand hervorstehende Rastnasen (15a) an dem oder den Federarmen (15) an entsprechenden Gegenrastmittel des Steckverbindergehäuses (21) ein- oder hintergreifen und den Steckverbinder (20) mit der Leiterplatte (10) verrasten.

9. Leiterplattensteckverbindung (1) gemäß einem der vorhergehenden Ansprüche, **dadurch gekennzeichnet, dass** beim Einstecken des Steckverbinders (20) auf den Einsteckabschnitt (12) der Leiterplatte (10) der oder die von der Leiterplatte ausgebildeten federnden Rastarme (15) innerhalb der Leiterplattenebene in einer Richtung quer zur Einsteckrichtung federnd ausgelenkt werden.

10. Leiterplattensteckverbindung (1) gemäß einem der vorhergehenden Ansprüche, **dadurch gekennzeichnet, dass** die Kontakte im Bereich des Einsteckabschnitts (12) als nicht federnde Kontakt-Pads wenigstens auf einer Oberseite oder Unterseite der Leiterplatte (20) ausgebildet sind und die Kontakte des Steckverbinders (20) als Federkontakte ausgebildet sind.
